# EUROPÄISCHE PATENTSCHRIFT

(11) **EP 1 570 164 B1**
(45) Veröffentlichungstag und Bekanntmachung des Hinweises auf die Patenterteilung: **05.07.2006**
(21) Anmeldenummer: 03788830.2
(22) Anmeldetag: 02.12.2003
(51) Int. Cl.: F02D 41/20, H01L 41/04

(54) **VERFAHREN UND ANORDNUNG ZUM ANSTEUERN EINES PIEZOELEKTRISCHEN AKTORS**
METHOD AND ARRANGEMENT FOR TRIGGERING A PIEZOELECTRIC ACTUATOR
PROCEDE ET DISPOSITIF POUR COMMANDER UN ACTIONNEUR PIEZOELECTRIQUE

(30) Priorität: 09.12.2002 DE 10257468
(43) Veröffentlichungstag der Anmeldung: 07.09.2005
(73) Patentinhaber: SIEMENS AKTIENGESELLSCHAFT, 80333 München (DE)
(72) Erfinder: FEDROW, Sascha, 93093 Donaustauf (DE); LEHMANN, Stefan, 93053 Regensburg (DE); LOMMER, Jürgen, 93449 Geigant (DE)
(86) Internationale Anmeldenummer: PCT/DE2003/003958
(87) Internationale Veröffentlichungsnummer: WO 2004/053315

(56) Entgegenhaltungen:
- WO-A-00/45046
- DE-A- 1 798 339
- DE-A- 10 063 080
- DE-A- 19 905 340
- US-A- 5 387 834
- US-A- 5 482 213

## Beschreibung

Die Erfindung betrifft ein Verfahren und eine Anordnung zum Ansteuern eines piezoelektrischen Aktors, insbesondere eines durch einen piezoelektrischen Aktor betriebenen Hochdruckeinspritzventils einer Brennkraftmaschine.

Piezoelektrische Keramiken bestehen beispielsweise aus Bleizirkonat-Titanat-Keramiken. Ein piezoelektrischer Aktor weist einen Stapel aufeinanderliegender Piezoelemente auf, der beim Beaufschlagen mit einer Spannung schnell seine Länge um eine u. a. von der Spannung abhängige Strecke verändert. Vor allem die Änderungsgeschwindigkeit und die hohen Kräfte machen die piezoelektrische Keramik für den Einsatz bei Einspritzventilen interessant.

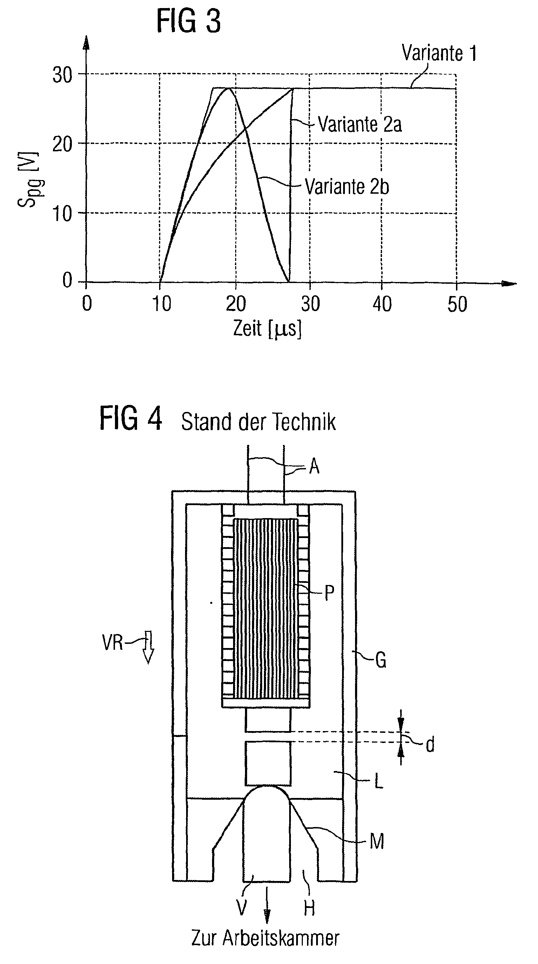

Da sich jedoch die Länge des piezoelektrischen Aktor nicht nur aufgrund der angelegten Spannung, sondern auch aufgrund der Temperatur des Aktors ändert, wird, wie in Figur 4 dargestellt, bei der Konstruktion eines von einem piezoelektrischen Aktor betätigten Ventils ein Spalt vorgesehen, der als Toleranzbereich für diese thermische Längenänderung dient.

Dennoch kann es im Betrieb vorkommen, dass die Längenänderung des piezoelektrischen Aktors diesen Toleranzspalt überschreitet und so, ohne dass der Aktor angesteuert wird, bereits das Ventil betätigt.

In Figur 4 ist ein Hochdruckeinspritzventil einer Brennkraftmaschine schematisch dargestellt, bei dem das Ventil im dargestellten Zustand geschlossen ist. Die Arbeitskammer des Hochruckeinspritzventils ist hier nicht dargestellt. Der piezoelektrische Aktor P weist zwei Anschlüsse A auf und ist von einem Gehäuse G umgeben.

Wird nun eine positive Spannung an den Anschlüssen A des piezoelektrischen Aktor P angelegt, so verlängert sich der Aktor P in Richtung der Vorzugspolarisierung der piezoelektrischen Keramik (siehe Pfeil VR in Figur 4). Das Hochdruckeinspritzventil weist einen Spalt d auf, der als Sicherheitsabstand für thermische Längenänderungen der Piezokeramik dient. Dieser Spalt d weist typischerweise ein Maß zwischen 3 und 5 µm auf.

Das hier dargestellte Hochdruckventil weist einen Niederdruckbereich L und einen Hochdruckbereich H auf, die durch eine Membran M getrennt werden.

Treten nun am piezoelektrischen Aktor P aufgrund von widrigen Umgebungseinflüssen Längenänderungen auf, die über das Maß dieses Spaltes d hinaus gehen, so drückt der piezoelektrische Aktor P bereits im Ruhezustand gegen den Ventilsitz V, was letztendlich zu einer Leckage am Ventil führen kann. Aufgrund dieser Leckage kann dann in einem Druckspeicher und in dem von diesem versorgten Hochdruckbereich H kein für die Funktion der Brennkraftmaschinen notwendiger Druck aufgebaut werden, was dazu führt, dass die Brennkraftmaschine versagt.

Soll in einem solchen Zustand die Brennkraftmaschine gestartet werden, beispielsweise nach einem vorangegangenen längeren Betrieb mit nachfolgendem Abstellen der Brennkraftmaschine, so kann aufgrund der Freisetzung von Kraftstoff aus dem Steuerraum in eine Leckageleitung ein Druckaufbau im Druckspeicher und somit auch im Hochdruckbereich H erheblich erschwert oder verzögert werden. Der Aufbau eines gewissen Mindestsystemdrucks, der typischerweise einige 100 bar beträgt, ist jedoch notwendig, um überhaupt eine Einspritzung zu ermöglichen.

Aus der Patentschrift DE 199 05 340 C2 ist ein Verfahren und eine Anordnung zur Voreinstellung und dynamischen Nachführung piezoelektrischer Aktoren bekannt. Hier wird der gepulsten Ansteuerspannung ein Gleichspannungssignal überlagert. Dieses Gleichspannungssignal bewirkt eine Längenänderung des piezoelektrischen Aktors sowohl in positiver, als auch in negativer Richtung. Auf diese Weise können temperaturbedingte Längenänderungen kompensiert werden.

Weiter ist eine Aktorsteuerung und ein zugehöriges Verfahren bekannt (DE 100 63 080 A1), bei dem die Ladung des Aktors in Abhängigkeit von der Temperatur des Aktors eingestellt wird, um temperaturbedingte Schwankungen des Aktorhubs zu vermeiden.

Auch ist eine Steuerschaltung für einen piezoelektrischen Aktor bekannt (US 5,387,834 A), bei der die Ansteuerzeiten eines Schalttransistors in einem Speicher als Funktion einer Temperatur hinterlegt sind.

Die Erfindung besteht darin, ein Verfahren und eine Anordnung zum Ansteuern eines piezoelektrischen Aktors zu schaffen, die es auf einfache Weise erlauben, falls die Länge des piezoelektrischen Aktors aufgrund eines abweichenden Systemverhaltens eine maximal zulässige Länge überschreitet, diese durch Ansteuerung mit einer negativen Spannung auf eine zulässige Länge zu reduzieren.

Diese Aufgabe wird erfindungsgemäß durch ein Verfahren mit den im Patentanspruch 1 und durch eine Anordnung mit den im Patentanspruch 8 angegebenen Merkmalen gelöst.

Das erfindungsgemäße Verfahren löst die Aufgabe dadurch, dass zunächst zumindest eine physikalisch Messgröße, die von der aktuellen Länge des piezoelektrischen Aktors abhängt, erfasst und ausgewertet wird. Anschließend wird abhängig von dieser Größe, falls die ermittelte Länge des piezoelektrischen Aktors dies erfordert, dieser mit einer negativen Spannung beaufschlagt.

Hier wird der piezoelektrische Effekt so genutzt, dass die piezoelektrische Keramik bei Beaufschlagung mit einer negativen Spannung ihre Länge ebenfalls schnell um eine festgelegte Strecke verringert.

Bevorzugte Ausführungsformen der Erfindung sind in den Unteransprüchen angeführt.

Die erfindungsgemäße Anordnung weist eine Spannungsquelle, eine Endstufe, eine Steuereinheit, eine Verpoleinrichtung und zumindest einen piezoelektrischen Aktor auf.

Die Steuereinheit erfasst eine physikalische Messgröße, die abhängig von der aktuellen Länge des zumindest einen piezoelektrischen Aktors ist. In Abhängigkeit von dieser Messgröße steuert die Steuereinheit die Endstufe an. Überschreitet die Messgröße einen vorbestimmten Schwellenwert, so wird nun der zumindest eine piezoelektrische Aktor mit einer von der Endstufe generierten und von Verpoleinrichtung im geänderten Spannungen beaufschlagt. Aufgrund dieser negativen Spannung verkürzt sich der piezoelektrische Aktor.

Durch das erfindungsgemäße Verfahren und die erfindungsgemäße Anordnung können temperaturbedingte Längenänderungen des piezoelektrischen Aktors auf einfache Weise ausgeglichen werden, ohne dass Änderungen am piezoelektrischen Aktor selbst oder am Gesamtsystem vorgenommen werden müssen.

Auch wird durch die kurzzeitige Ansteuerung des piezoelektrischen Aktors mit einer negativen Spannung der piezoelektrischen Keramik bzw. deren Polarisation kein Schaden zugefügt.

Mehrere Ausführungsbeispiele des erfindungsgemäßen Verfahrens und der Anordnung werden im Folgenden anhand der schematischen Zeichnungen näher erläutert. Es zeigen:
- Figur 1: ein Blockschaltbild eines ersten Ausführungsbeispiels einer erfindungsgemäßen Anordnung,
- Figur 2: ein Ablaufdiagramm, das die Schritte eines Ausführungsbeispiels eines erfindungsgemäßen Verfahrens wiedergibt,
- Figur 3: drei Ausführungsbeispiele eines Spannungsverlaufs am piezoelektrischen Aktor und
- Figur 4: ein Hochdruckeinspritzventil einer Brennkraftmaschine, das einen piezoelektrischen Aktor aufweist.

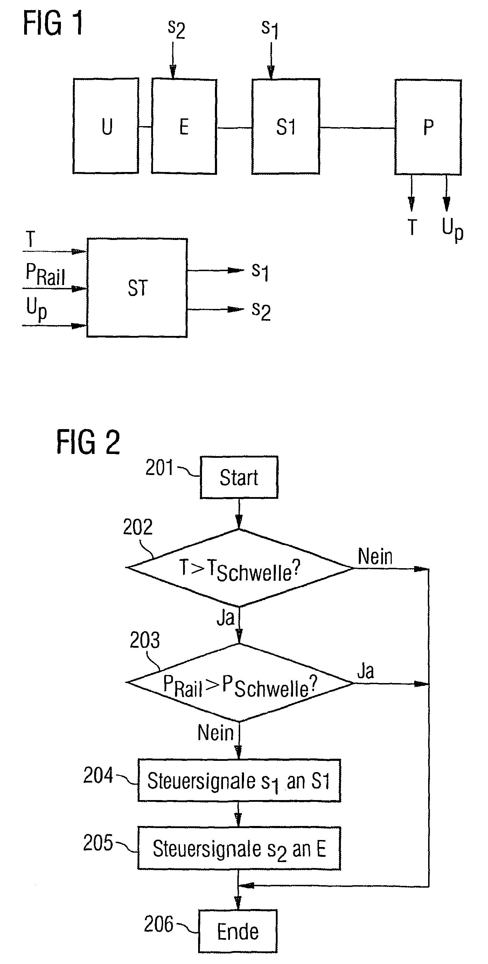

Figur 1 zeigt ein Blockschaltbild eines ersten Ausführungsbeispiels einer erfindungsgemäßen Anordnung, die eine Spannungsquelle U, eine Endstufe E, eine Verpoleinrichtung S1, einen piezoelektrischen Aktor P und eine Steuereinheit ST aufweist. Die Spannungsquelle U versorgt die Endstufe E mit Energie. Die Endstufe E ist mit der Verpoleinrichtung S1 elektrisch verbunden.

Die Steuereinheit ST weist drei Eingänge und zwei Ausgänge auf. Abhängig von diesen Eingangssignalen steuert diese Steuereinheit ST die Verpoleinrichtung S1 an.

Die Endstufe E kann sowohl von der Steuereinheit ST durch das Steuersignal S₂, als auch von einer nicht dargestellten Steuereinheit angesteuert werden.

Im Normalbetrieb wird der Aktor P so angesteuert, dass er sich aufgrund der zwischen dem positiven und dem negativen Anschluss A angelegten positiven Spannung in Richtung der Vorzugsrichtung VR ausdehnt (vgl. Bezugszeichen Fig. 4). Wird nun ein zu langer Aktor detektiert, so wird dieser mit einer im Vergleich zum Normalbetrieb negativen Spannung beaufschlagt.

Als Eingangsgrößen der Steuereinheit ST werden in diesem Ausführungsbeispiel zum einen der Druck p_{Rail} in einem (nicht dargestellten) Druckspeicher und/ oder die Temperatur T der piezoelektrischen Aktoren P herangezogen. Zusätzlich kann auch die Spannung Up über dem piezoelektrischen Aktor P als Eingangsgröße herangezogen werden. Abhängig von diesen Eingangsgrößen erzeugt die Steuereinheit ST entsprechende Ausgangssignale S₁ und S₂.

Der Druckspeicher (Rail) versorgt einen Hochdruckbereich (vgl. Bezugszeichen H, Figur 4) mit einem unter Druck stehenden Medium, beispielsweise einer Flüssigkeit. Überschreitet die Länge des Aktors P nun eine maximal zulässige Länge d, so kann sowohl im Druckspeicher, als auch im Hochdruckbereich H kein Druck aufgebaut werden. Dies führt im hier aufgezeigten Ausführungsbeispiel dazu, dass die Brennkraftmaschine nicht gestartet werden kann.

Beim Betrieb der Brennkraftmaschine bedeutet diese Überschreitung der maximal zulässigen Länge D eine Öffnungstendenz des vom Aktor P angesteuerten Einspritzventils V, selbst wenn dieses nicht aktiv elektrisch über die Anschlüsse A angesteuert wird. Für den Fall eines "Heißstarts" der Brennkraftmaschine bedeutet dies, dass der Druckaufbau im Druckspeicher (Rail) nicht oder nicht rasch in einem Ausmaß aufgebaut werden kann, das für den Beginn der Kraftstoffeinspritzung erforderlich ist.

Ein Ablaufdiagramm eines Ausführungsbeispiels des erfindungsgemäßen Verfahrens ist in Figur 2 dargestellt. In Schritt 201 wird das Verfahren gestartet und im Anschluss daran wird in Schritt 202 überprüft, ob die Temperatur T eines oder mehrer piezoelektrischer Aktoren P eine bestimmte Schwellentemperatur T_{Schwelle} überschreitet.

Abhängig vom Ergebnis dieses Vergleichs wird entweder zum Ende dieses Verfahrens verzweigt (Schritt 206) oder es wird nach Schritt 203 verzweigt.

Ein Überprüfen der Aktortemperatur T ist zum Ausführen des erfindungsgemäßen Verfahrens nicht zwingend erforderlich, es bietet jedoch den Vorteil, dass einer temperaturbedingten Längenänderung des piezoelektrischen Aktors ohne eine für den Benutzer merkliche Zeitverzögerung entgegengewirkt werden kann.

In Schritt 203 wird nun der Druck p_{Rail} in dem Druckspeicher mit einem vorgegebenen Schwellenwert P_{Schwelle} verglichen. Ist der Druck p_{Rail} größer als der vorgegebenen Schwellenwert P_{Schwelle}, so wird zum Ende des Verfahrens verzweigt, da der piezoelektrische Aktor P ordnungsgemäß arbeitet und das vom Aktor p angesteuerte Ventil keine Leckage aufweist. Liegt der ermittelte Druck p_{Rail} und/ oder die Temperatur T unter bzw. oberhalb der vorgegebenen Schwelle so wird in Schritt 204 die Verpoleinrichtung S2 angesteuert, die die Anschlüsse A (siehe Fig. 4) des piezoelektrischen Aktors P entgegen der beim Normalbetrieb üblichen Anschlussrichtung verpolt. Im Anschluss daran wird die sendet die Steuereinheit ST das Ansteuersignal s₂ an die Endstufe E, die dann eine Ansteuerspannung erzeugt, bevor dann das erfindungsgemäße Verfahren im Schritt 206 beendet wird. Sobald dann ein Druckaufbau im Hochdruckbereich H möglich ist, kann die negative Spannung am piezoelektrischen Aktor P abgeschaltet werden bzw. die Kontraktion nachlassen, da dieser Druck dann das Ventil geschlossen hält.

Bei der Endstufe E handelt es sich vorzugsweise um eine Umschwingendstufe, wie sie beispielsweise in der Offenlegungsschrift DE 199 44 733 A1 offenbart ist.

Figur 3 zeigt drei Ausführungsbeispiele eines Spannungspulses, mit denen der Aktor P entgegen seiner üblichen Polung angesteuert werden kann. Die Variante 1 zeigt eine Spannungsform, die zunächst mit einer konstanten Steigung bis zu einer Maximalspannung ansteigt und dann konstant bleibt. Diese Spannung wird von der Endstufe E als positive Spannung erzeugt und der Umpolvorrichtung S1 zugeführt. Die Verpolvorrichtung S1 schaltet den positiven Ausgang der Endstufe E auf den negativen Eingang des piezoelektrischen Aktors P. Der negative Ausgang der Endstufe E wird auf den positiven Eingang des piezoelektrischen Aktors P geschaltet. Der Aktor P wird somit mit einer negativen Spannung aufgeladen, wodurch dieser seine Länge verkürzt.

Die beiden anderen Ausführungsbeispiele des Spannungspulses, hier als Variante 2a und Variante 2b bezeichnet, machen sich die physikalische Eigenschaft des piezoelektrischen Aktors P zum Nutzen, dass der Aktor sich bereits bei einer kurzzeitig angelegten negativen Spannung zusammenzieht und im Anschluss daran sich erst mit einer gewissen Zeitverzögerung wieder ausdehnt. Die Variante 2a stellt einen herkömmlichen Ladepuls der Umschwingendstufe E dar, der hier aufgrund der benötigten kleinen Ladung vorzeitig abgebrochen wird.

In Variante 2b erzeugt die Endstufe einen Spannungspuls, der einer Sinushalbwelle entspricht. Die Periodendauer der Sinushalbwelle ist hier kürzer, als bei einer Ansteuerung des Aktors P im Normalbetrieb.

Die hier aufgezeigte Anordnung und das Ansteuerverfahren bieten den Vorteil, dass mit der bereits vorhandenen Endstufe E und einer technisch einfachen Verpoleinrichtung S₁ die Länge des piezoelektrischen Aktors P soweit verkürzt werden kann, dass ein Start der Brennkraftmaschine möglich ist.

Auch bieten die kurzen negativen Spannungspulse den Vorteil, dass der piezoelektrische Aktor P nicht beschädigt wird, da die Zeitdauer in der der Aktor P mit einer negativen Spannung angesteuert wird sehr kurz ist.

## Patentansprüche

1. Verfahren zum Ansteuern eines durch einen piezoelektrischen Aktor betriebenen Hochdruckeinspritzventils einer Brennkraftmaschine, das die folgenden Verfahrensschritte aufweist:
- Erfassen und Auswerten zumindest einer physikalischen Messgröße (T, P_{Rail}, Uₚ), die Aufschluss über die aktuelle Länge des zumindest einen piezoelektrischen Aktors (P) gibt,
- Überprüfen, ob die Messgröße (T, P_{Rail}, Uₚ) einen vorbestimmten Schwellenwert über- oder unterschreitet,
- Ansteuern des piezoelektrischen Aktors (P) im Ruhezustand über eine Verpoleinrichtung (S1) in Abhängigkeit von dieser Überprüfung, falls die Über- oder Unterschreitung der aktuellen Länge des piezoelektrischen Aktors (P) einen Druckaufbau in einem Hochdruckbereich (H) des Hochdruckeinspritzventils verhindert, wobei die Ansteuerung mit einer Spannung erfolgt, die eine Längenänderung des Aktors (P) zur Folge hat, die der Über- oder Unterschreitung entgegenwirkt, und
- Abschalten der Spannung, sobald die Länge des Aktors (P) einen vorgegebenen Wert erreicht hat oder nach einer vorgegebenen Zeitdauer.

2. Verfahren nach Anspruch 1, **dadurch gekennzeichnet, dass** die physikalische Messgröße (T) unmittelbar von der Länge des piezoelektrischen Aktors (P) abhängt.

3. Verfahren nach Anspruch 1, **dadurch gekennzeichnet, dass** die physikalische Messgröße (p_{Rail}) mittelbar von der Länge des piezoelektrischen Aktors (P) abhängt.

4. Verfahren nach Anspruch 2, **dadurch gekennzeichnet, dass** es sich bei der physikalischen Messgröße um eine Temperatur (T) des Aktors (P) handelt und der Aktor (P) angesteuert wird, sobald diese einen vorgegebenen Schwellwert (T_{Schwelle}) überschreitet.

5. Verfahren nach Anspruch 3, **dadurch gekennzeichnet, dass** es sich bei der physikalischen Messgröße um einen Druck (P_{Rail}) in einem Hochdruckbereich (H) handelt und der Aktor (P) angesteuert wird, sobald dieser einen vorgegebenen Schwellwert (P_{Schwelle}) unterschreitet.

6. Verfahren nach einem der Ansprüche 1 bis 5, **dadurch gekennzeichnet, dass** die Spannung, mit der der piezoelektrische Aktor (P) angesteuert wird, eine negative Gleichspannung ist.

7. Verfahren nach einem der Ansprüche 1 bis 5, **dadurch gekennzeichnet, dass** die piezoelektrische Aktor P mit einer negativen Spannung mit der Form einer sinusförmigen Halbwelle beaufschlagt wird.

8. Anordnung zum Ansteuern eines durch einen piezoelektrischen Aktor betriebenen Hochdruckeinspritzventils, die aufweist:
- eine Spannungsquelle (U) zum Ansteuern des piezoelektrischen Aktors (P),
- eine erste Verpoleinrichtung (S1), die die Polarität der Spannung am piezoelektrischen Aktor (P) in Abhängigkeit von einem Steuersignal (s₁) einstellt, sodass der positive Pol des piezoelektrischen Aktors (P) von dieser einen Spannungsquelle (U) entweder mit einem negativen, oder mit einem positiven Potential beaufschlagbar ist, und
- eine Steuereinheit (ST), die Mittel zum Erfassen und Auswerten einer physikalischen Messgröße (T, PRail, Up) und zum Vergleichen dieser Messgröße (T, PRAil, Up) mit einem vorbestimmten Schwellenwert aufweist, wobei die Messgröße (T, P_{Rail}, Uₚ) Aufschluss über die aktuelle Länge des zumindest einen piezoelektrischen Aktors (P) gibt, und wobei die Verpoleinrichtung (S1) in Abhängigkeit von diesem Vergleich angesteuert wird, falls eine Über- oder Unterschreitung der aktuellen Länge des piezoelektrischen Aktors (P) einen Druckaufbau in einem Hochdruckbereich (H) des Hochdruckeinspritzventils verhindert.

9. Anordnung nach Anspruch 8, **dadurch gekennzeichnet, dass** zwischen der Spannungsquelle (U) und der Umpolvorrichtung (S1) eine Endstufe (E) angeordnet ist, die eine Spannung (Uₚ) zum Ansteuern des piezoelektrischen Aktors (P) erzeugt.

10. Steuergerät einer Brennkraftmaschine, das eine Anordnung gemäß einem der Ansprüche 8 oder 9 aufweist.

## Claims

1. Method for driving an internal combustion engine's high-pressure injection valve operated by a piezoelectric actuator, which valve has the following procedural steps:
- registering and evaluating at least one physical variable (T, P_{Rail}, Uₚ) providing information about the current length of the at least one piezoelectric actuator (P),
- checking whether the variable (T, P_{Rail}, Uₚ) exceeds or falls below a predefined threshold,
- driving the piezoelectric actuator (P) in the idle condition via a polarity-reversal device (S1) as a function of said check if any exceeding or falling below that has been registered in the current length of the piezoelectric actuator (P) prevents a build-up of pressure in a high-pressure zone (H) of the high-pressure injection valve, with said driving being effected by means of a voltage causing a linear change in the actuator (P) counteracting said instance of exceeding or falling below, and
- disconnecting said voltage as soon as the length of the actuator (P) has reached a predefined value or after a predefined period of time.

2. Method according to claim 1 **characterized in that** the physical variable (T) is directly dependent on the length of the piezoelectric actuator (P).

3. Method according to claim 1 **characterized in that** the physical variable (P_{Rail}) is indirectly dependent on the length of the piezoelectric actuator (P).

4. Method according to claim 2 **characterized in that** the physical variable is a temperature (T) of the actuator (P) and **in that** the actuator (P) is driven as soon as said temperature exceeds a predefined threshold (T_{Schwelle}).

5. Method according to claim 3 **characterized in that** the physical variable is a pressure (p_{Rail}) in a high-pressure zone (H) and **in that** the actuator (P) is driven as soon as said pressure falls below a predefined threshold (P_{Schwelle}).

6. Method according to one of claims 1 to 5 **characterized in that** the voltage with which the piezoelectric actuator (P) is driven is a negative direct-current voltage.

7. Method according to one of claims 1 to 5 **characterized in that** the piezoelectric actuator P is subjected to a negative voltage having the form of a sinusoidal half-wave.

8. Arrangement for driving a high-pressure injection valve operated by a piezoelectric actuator, which arrangement has:
- a voltage source (U) for driving the piezoelectric actuator (P),
- a first polarity-reversal device (S1) which sets the polarity of the voltage applied to the piezoelectric actuator (P) as a function of a control signal (s₁) so that the positive pole of the piezoelectric actuator (P) can be subjected by said single voltage source (U) to either a negative or a positive potential, and
- a control unit (ST) having means for registering and evaluating a physical variable (T, p_{Rail}, Up) and for comparing said variable (T, p_{Rail}, Uₚ) with a predefined threshold, with said variable (T, p_{Rail}, Uₚ) providing information about the current length of the at least one piezoelectric actuator and with the polarity-reversal device (S1) being driven as a function of said comparison if any exceeding or falling below that has been registered in the current length of the piezoelectric actuator (P) prevents a build-up of pressure in a high-pressure zone (H) of the high-pressure injection valve.

9. Arrangement according to claim 8 **characterized in that** located between the voltage source (U) and the polarity-reversal device (S1) is an end stage (E) that generates a voltage (Uₚ) for driving the piezoelectric actuator (P).

10. An internal combustion engine's control device having an arrangement according to one of claims 8 or 9.

## Revendications

1. Procédé pour commander une soupape d'injection à haute pression d'un moteur à combustion interne actionnée par un actionneur piézoélectrique, qui présente les étapes suivantes:
- détecter et évaluer au moins une grandeur de mesure physique (T, p_{Rail}, Uₚ), qui permet de tirer une conclusion sur la longueur actuelle de l'actionneur piézoélectrique (P),
- vérifier si la grandeur de mesure (T, P_{Rail}, Uₚ) est supérieure ou inférieure à une valeur de seuil prédéterminée;
- commander l'actionneur piézoélectrique (P) à l'état de repos par l'intermédiaire d'un dispositif d'inversion de polarité (S1) en fonction de cette vérification, au cas où le dépassement supérieur ou inférieur de la longueur actuelle de l'actionneur piézoélectrique (P) empêche l'établissement d'une pression dans une zone à haute pression (H) de la soupape d'injection à haute pression, dans lequel la commande est effectuée avec une tension qui provoque une variation de longueur de l'actionneur (P) qui s'oppose au dépassement supérieur ou inférieur; et
- couper la tension, dès que la longueur de l'actionneur (P) atteint une valeur prédéterminée ou après une durée prédéterminée.

2. Procédé selon la revendication 1, **caractérisé en ce que** la grandeur de mesure physique (T) dépend directement de la longueur de l'actionneur piézoélectrique (P).

3. Procédé selon la revendication 1, **caractérisé en ce que** la grandeur de mesure physique (p_{Rail}) dépend indirectement de la longueur de l'actionneur piézoélectrique (P).

4. Procédé selon la revendication 2, **caractérisé en ce que** la grandeur de mesure physique est une température (T) de l'actionneur (P) et l'actionneur (P) est commandé dès que celle-ci dépasse une valeur de seuil prédéterminée (T_{Seuil}).

5. Procédé selon la revendication 3, **caractérisé en ce que** la grandeur de mesure physique est une pression (p_{Rail}) dans une zone à haute pression (H) et l'actionneur (P) est commandé dès que celle-ci devient inférieure à une valeur de seuil prédéterminée (P_{Seuil}).

6. Procédé selon l'une quelconque des revendications 1 à 5, **caractérisé en ce que** la tension, avec laquelle l'actionneur piézoélectrique (P) est commandé, est une tension continue négative.

7. Procédé selon l'une quelconque des revendications 1 à 5, **caractérisé en ce que** l'actionneur piézoélectrique (P) est alimenté avec une tension négative ayant la forme d'une demi-onde sinusoïdale.

8. Dispositif pour commander une soupape d'injection à haute pression actionnée par un actionneur piézoélectrique, qui comprend:
- une source de tension (U) pour commander l'actionneur piézoélectrique (P);
- un premier dispositif d'inversion de polarité (S1), qui règle la polarité de la tension à l'actionneur piézoélectrique (P) en fonction d'un signal de commande (s₁), de telle façon que le pôle positif de l'actionneur piézoélectrique (P) puisse être alimenté par cette source de tension (U) soit avec un potentiel négatif soit avec un potentiel positif; et
- une unité de commande (ST), qui comporte des moyens pour détecter et évaluer une grandeur de mesure physique (T, P_{Rail}, Up) et pour comparer cette grandeur de mesure (T, P_{Rail} Up) avec une valeur de seuil prédéterminée, dans lequel la grandeur de mesure (T, _{PRail}, Up) permet de tirer des conclusions sur la longueur actuelle du au moins un actionneur piézoélectrique (P), et dans lequel le dispositif d'inversion de polarité (S1) est commandé en fonction de cette comparaison, au cas où un dépassement supérieur ou inférieur de la longueur actuelle de l'actionneur piézoélectrique (P) empêche l'établissement d'une pression dans une zone à haute pression (H) de la soupape d'injection à haute pression.

9. Dispositif selon la revendication 8, **caractérisé en ce qu'**un étage final (E) est disposé entre la source de tension (U) et le dispositif d'inversion de polarité (S1), étage final qui produit une tension (Up) pour commander l'actionneur piézoélectrique (P).

10. Appareil de commande d'un moteur à combustion interne, qui comporte un dispositif selon l'une quelconque des revendications 8 ou 9.
